# EUROPEAN PATENT SPECIFICATION

(11) **EP 2 734 020 B1**
(45) Date of publication and mention of the grant of the patent: **12.07.2017**
(21) Application number: 12193249.5
(22) Date of filing: 19.11.2012
(51) Int. Cl.: H05K 7/20, H01L 23/427, F28D 15/06, F28D 15/02

(54) **Cooling arrangement with a two-phase thermosyphon for cooling a multiplicity of electric devices**
Kühlanordnung mit einem zweiphasigen Wärmesyphon zum Kühlen einer Mehrzahl elektrischer Vorrichtungen
Agencement de refroidissement comprenant un thermosiphon à deux phases destiné à refroidir une multiplicité de dispositifs électriques

(43) Date of publication of application: 21.05.2014
(73) Proprietor: ABB Schweiz AG, 5400 Baden (CH)
(72) Inventor: Agostini, Bruno, 8006 Zürich (CH); Agostini, Francesco, 4800 Zofingen (CH); Habert, Mathieu, 4310 Rheinfelden (CH)
(74) Representative: ABB Patent Attorneys

(56) References cited:
- EP-A1- 2 282 624
- WO-A1-2011/017385
- DE-A1- 19 960 841
- US-A1- 2010 118 493
- US-B1- 6 223 810

## Description

### Field of the invention

The present invention relates to a cooling arrangement for cooling a multiplicity of electric devices such as e.g. semiconductor devices wherein the cooling arrangement comprises a two-phase thermosyphon.

### Technical background

Cooling is one of the critical aspects of any electrical product as all electrical components of such product typically dissipate heat. For example, semiconductor devices comprised in an electrical product used for e.g. controlling, regulating and/or amplifying electrical currents generally dissipate significant amounts of heat during operation. Therein, generally, the higher the power in play the higher are the total heat losses dissipated by the electrical components of the electrical product. As, for example in semiconductor devices, power densities have significantly increased steadily in recent years, so has the importance of an effective cooling system in product design. Advantages of a good cooling system comprise, inter alia, higher reliability of the electrical product and its components, higher possible power density in the electrical components, higher possible operating ambient temperature and/or the ability of using smaller semiconductor devices.

An example of an electrical product or of electrical components comprised in such product needing effective cooling are power module assemblies typically comprising one or a plurality of power semiconductor devices such as MOSFETs or IGBTs. Such power module assemblies are usually air-cooled or, for larger powers, liquid-cooled. The power modules may be mounted in parallel and/or in series such that heat losses may be effectively distributed over a large number of components. Therein, a coolant medium comprising e.g. gas such as air or alternatively comprising a liquid such as e.g. de-ionized water is typically conducted to each of the electrical components in order to absorb dissipated heat. The coolant medium is then further conducted towards a heat sink for releasing the absorbed heat.

Generally, for conducting the coolant medium towards the electrical components and towards the heat sink, the cooling medium may be actively driven using a separate device such as a blower or a pump. However, such separate device may be energy-consuming and may add to the overall complexity of the cooling arrangement.

As an alternative, the cooling arrangement may comprise a thermosyphon in which a cooling medium is passively conducted from the heat sink towards the heat dissipating electrical components and vice versa. A thermosyphon is a device which is adapted for passive heat exchange based on natural convection. Therein, a liquid coolant medium or a coolant medium comprising a mixture of liquid and gaseous components may circulate within the thermosyphon without the necessity of any driving device such as a pump.

A principle underlying the thermosyphon uses the fact that convective movement of a coolant medium starts when the coolant medium in a loop is locally heated, causing it to expand and become less dense, and thus more buoyant than the cooler surrounding coolant medium at lower portion of the loop. Convection moves heated coolant medium upwards in the system as it is simultaneously replaced by cooler coolant medium returning by gravity. Ideally, the coolant medium flows easily because a good thermosyphon should have very little hydraulic resistance.

An example of a thermosyphon is described in EP 2 031 332.

Specifically, a thermosyphon may use two-phase cooling principles in which a phase transition from a liquid phase to a gaseous phase, and vice versa, occurs and serves for absorbing energy from a heat dissipating component and releasing energy to a heat sink, respectively.

However, when using a conventional two-phase loop thermosyphon in a cooling arrangement for cooling a multiplicity of electric components, insufficient cooling of one or a few of the electric components has been observed under certain conditions as will be described in more detail further below.
Further state of the art is disclosed in DE 199 60 841 A1 and US 2010/0118493A1.

### Summary of the invention

It may be an object of the present invention to provide a cooling arrangement for a multiplicity of electric devices which cooling arrangement, inter alia, provides for increased reliability of sufficient cooling for each of the electric devices.

Such object may be met by the subject matter of claim 1. Advantageous embodiments of the invention are defined in the dependent claims.

According to an aspect of the present invention, a cooling arrangement for a multiplicity of electric devices is proposed. The cooling arrangement includes a two-phase thermosyphon which comprises a multiplicity of evaporators, each evaporator being in thermal contact with at least one of the electric devices. Furthermore, the cooling arrangement includes at least one condenser and a plurality of inlet channels and outlet channels. Therein, each of the evaporators is in fluid communication with the condenser via an inlet channel connecting an outlet of the condenser with an inlet of the respective evaporator and is in fluid communication with the condenser via an outlet channel connecting an outlet of the respective evaporator with an inlet of the condenser. The cooling arrangement is characterized by the fact that the two-phase thermosyphon additionally comprises at least one controllable valve being arranged in at least one of the inlet channels and outlet channels, wherein the controllable valve is adapted for adjusting a local fluid pressure loss in the respective channel.

Ideas to the present invention may be seen as based on the following observations and perceptions:

When using a conventional two-phase loop thermosyphon in a cooling arrangement for cooling a multiplicity of electric devices, several problems have been observed. For example, due to density differences between a liquid phase and a vapor phase comprised in the two-phase coolant medium circulating in the thermosyphon, a flow of such two-phase coolant medium is more complex than in a purely liquid flow. For example, because of gravity, stratification between the liquid phase and vapor phase may occur.

As a result of such stratification, each evaporator of a multiplicity of evaporators comprised in the cooling arrangement may receive a different amount of heat absorbing coolant medium, even for equally distributed heat loads over the electric devices to be cooled.

Furthermore, the difference of density of the liquid and vapor phases may induce large velocity differences between liquid and vapor phases and may result in instabilities in the cooling operation. These instabilities may cause temperature oscillations and pressure waves which may be detrimental to the reliability of the cooling arrangement.

Furthermore, each of the electric devices to be cooled may dissipate different amounts of heat such that different heat loads may be applied to each of the evaporators of the cooling arrangement being in thermal contact with the respective electric devices. Accordingly, different amounts of vapor may be generated at each evaporator. This may result in a dramatically increase of maldistributions and instabilities within the cooling arrangement.

In other words, in a conventional cooling arrangement comprising a loop two-phase thermosyphon, a main problem to be solved may be seen in the flow maldistribution of coolant medium due to a difference of pressure head and bubble generation rate in the various evaporators comprised in the cooling arrangement.

The cooling arrangement proposed herein comprises a loop two-phase thermosyphon in which at least one controllable valve is arranged in at least one of the inlet channels and outlet channels. The controllable valve is adapted for adjusting a local fluid pressure loss in the respective channel.

In other words, according to embodiments of the present invention, one ore more valves are added at the inlet and/or outlet channel of at least one of the evaporators comprised in the cooling arrangement in order to change a fluid mass flow through the respective evaporator by adding a controllable local pressure loss.

The proposed cooling arrangement including additional controllable valves may provide various advantages. For example, by suitably adjusting local fluid pressure losses within the inlet channels and/or outlet channels conducting coolant medium to and from the evaporators, instabilities within the coolant circuit may be prevented. For example, the coolant flow may be forced into one direction only. Since, preferably, each controllable valve may be controlled and adjusted separately, the flow through each of the evaporators may be adapted to the current heat load applied to the respective evaporator. Accordingly, the proposed cooling arrangement may compensate for maldistributions of coolant medium due to e.g. the evaporator stacking.

In a specific example where the cooling arrangement is used for cooling a semiconductor power module and the electric devices to be cooled are semiconductor devices, a lifetime of each of the semiconductor devices may be controlled by adapting the cooling rate at each evaporator. For such purpose, the controllable valves associated with the evaporators may be specifically adjusted such that the flow of coolant medium through a respective evaporator is set in order to result in the required cooling rate.

Furthermore, in case of a power module failure, a damaged evaporator may be isolated, thus allowing the other evaporators to continue a save and reliable operation and containing a possible coolant medium leak of the whole system of the cooling arrangement.

Possible features and advantages of embodiments of the present invention shall be explained in more detail in the following.

The cooling arrangement proposed herein may be used for specifically and controllably cooling a multiplicity of electric devices. The electric devices may be any heat generating electric devices, e.g. semiconductor devices, particularly power semiconductor devices.

The cooling arrangement comprises a loop-type two-phase thermosyphon. While this thermosyphon may comprise only a single condenser it shall comprise a multiplicity of evaporators. Each of the evaporators is in thermal contact with at least one of the electric devices to be cooled. Preferably, the thermal contact is established by a direct mechanical contact between the evaporator and an associated electric device.

Preferably, the evaporators and the electric devices are arranged in a stack such that each electric device is interposed between two opposing evaporators and each evaporator is interposed between two opposing electric devices. Accordingly, in such stack, each electric device is submitted to a double side cooling.

Each of the evaporators is in fluid communication with the condenser via at least one inlet channel connecting an outlet of the condenser with an inlet of the respective evaporator. Furthermore, each of the evaporators is in fluid communication with the condenser via an outlet channel connecting an outlet of the respective evaporator with an inlet of the condenser. The inlet and outlet channels may be e.g. tubes, pipes, hoses, etc.

In the loop two-phase thermosyphon, a coolant medium coming from the condenser may flow through each one of the multiplicity of evaporators. As the evaporator is in thermal contact with at least one of the heat generating electric devices, heat is absorbed by the evaporator and is transferred to the coolant medium flowing through the evaporator. The heated coolant medium then returns to the condenser via the associated outlet channel. The condenser is in thermal contact with a heat sink such that heat previously absorbed in the coolant medium may be released within the condenser. Thereby, the cooling loop is closed and coolant medium can flow again towards the evaporators.

In such process of absorbing heat in the evaporators and releasing heat in the condenser, part of the coolant medium may be submitted to a phase transition from a liquid state to a vapor or gaseous state and vice versa. Due to such phase transition, heat may be absorbed and released more efficiently.

When heat is absorbed in an evaporator, the density of the coolant medium reduces. On the other hand, when heat is released in the condenser, density of the coolant medium increases. This effect is enhanced if phase transition occurs as the number of gas bubbles increases in the coolant medium upon heat absorption when flowing through an evaporator and is reduced again in the condenser upon heat release. Due to such locally varying density of the coolant medium, the thermosyphon may be gravity-driven. Accordingly, in such gravity-driven thermosyphon, no additional means for propelling the coolant medium is required. In other words, such gravity-driven thermosyphon does not need any pumps or blowers.

It shall be noted that the inlet channels and outlet channels do not necessarily connect the condenser and the evaporator directly but other devices such as further channels or for example further serially arranged evaporators or an insulating section may be interposed.

Preferably, the multiplicity of evaporators is arranged for establishing parallel fluid flow of coolant medium from and to the condenser. In other words, the evaporators and the inlet and outlet channels connecting the evaporators to the condenser shall be arranged such that coolant medium coming from the condenser may flow to each of the evaporators in parallel. Accordingly, one single condenser may supply cooling medium to a plurality of evaporators. For such purpose, the evaporators may be arranged geometrically parallel to each other thereby forming a stack of parallel evaporators with interposed electric devices. However, the evaporators may also be arranged in a geometrically non-parallel fashion as long as there is a functionally parallel, i.e. not serial, fluid flow flowing through two or more neighboring evaporators. For example, the evaporators may be arranged horizontally or vertically or in any other orientation. Similarly, the valves may be arranged horizontally or vertically or in any other orientation.

Preferably, the evaporators are arranged at different height levels with respect to the condenser. In other words, while in a gravity-driven thermosyphon the condenser shall be at the highest level such that all coolant medium coming from the evaporators with a reduced density may rise towards the condenser, the various evaporators shall be arranged at different height levels underneath the condenser, i.e. at different distances in gravity direction with respect to the condenser. For example, in a stack comprising multiple evaporators and interposed power semiconductor devices, the evaporators may be arranged parallel to each other at different height levels.

The number of controllable valves and the location at which one or more controllable valves are arranged within the channels of the thermosyphon may vary in different embodiments of the proposed cooling arrangement.

For example, the cooling arrangement may comprise a plurality of controllable valves wherein a controllable valve is arranged in each of plural ones of the inlet channels and outlet channels. In other words, a plurality of controllable valves is provided in the cooling arrangement wherein at least one controllable valve is provided in some but not necessarily all channels of the thermosyphon. The number, type and/or location of the controllable valves may be adapted taking into account for example cooling requirements of each of the electric devices being in thermal contact with a respective evaporator.

Alternatively, a controllable valve may be arranged in each of the inlet channels, wherein each controllable valve is adapted for adjusting a local fluid pressure loss of an inflow in the associated inlet channel. As an alternative or in addition hereto, a controllable valve may be arranged in each of the outlet channels, wherein each controllable valve is adapted for adjusting a local fluid pressure loss of an outflow in the respective outlet channel. In other words, a controllable valve may be arranged in each of the inlet channels and/or in each of the outlet channels. Thereby, fluid pressure losses in each of the inlet channels and/or each of the outlet channels may be controlled such that the flow of coolant medium through each of the evaporators may be precisely controlled.

According to a specific embodiment, the cooling arrangement comprises plural evaporators which are arranged serially with an outlet of a first evaporator being in fluid communication with an inlet of a neighboring second evaporator via an intermediate channel. In other words, while the proposed cooling arrangement should comprise at least one stack of evaporators and electric devices being arranged in parallel to each other as described above, in a specific embodiment, the cooling arrangement may comprise a plurality of stacks wherein the stacks are connected serially via one or more intermediate channels. Therein, coolant medium may flow e.g. first through inlet channels into a first stack and may then continue flowing through intermediate channels towards a second stack before returning to the condenser via associated outlet channels. Of course, more than two stacks with first and second evaporators may be arranged in series.

In such specific embodiment, the cooling arrangement may further comprise a connection channel connecting two intermediate channels and the cooling arrangement may further comprise at least one controllable valve arranged in one of the intermediate channels and the connection channel. Therein, the controllable valve is adapted for adjusting a local fluid pressure loss in the respective connection channel. Using such additional controllable valves in intermediate channels or connection channels may serve for controllably adjusting a fluid pressure loss in these channels and thereby determining a flow of coolant medium throughout these channels.

The one or more controllable valves arranged within one or more channels of the cooling arrangement may comprise various types of valves.

Preferably, the valves are one-way valves for defining a predetermined flow direction of the coolant medium in the cooling arrangement. In other words, the valves are adapted for allowing fluid flow only in one direction such that no back-flow may occur. Such one-way operation of the valves may help preventing any instabilities within the coolant medium flow in the cooling arrangement.

According to an embodiment, one or more of the valves comprised in the cooling arrangement may be a manual valve being manually settable to a fixed working point. Using such manual valves in the cooling arrangement, the system may be set initially to a fixed working point and can be changed during maintenance operation only. While this is a cheap solution, calibration runs for calibrating the manual valves are typically needed.

Alternatively or additionally, one or more of the valves may be provided as a thermostatic valve being adapted for automatically passively setting a working point depending on a measured temperature difference, a measured pressure difference, an absolute value and/or a measured heat load. Choosing thermostatic valves, the cooling arrangement may be implemented as a passive system in which fluid pressure losses are adjusted with the thermostatic valves according to measured or predetermined parameter values such as a temperature difference for example between the evaporator and the ambient air. This may allow cheap and easy implementation of the cooling arrangement while, however, possibly resulting in a limited operation range.

As a further alternative or in addition to other types of valves, one or more electro-controlled valves may be provided within the cooling arrangement. An electro-controlled valve is adapted for actively setting a working point in response to a control signal. For example, such electro-controlled valve may be actively controlled by an actuator such as e.g. a motor based on any feedback signal, for example based on a temperature, pressure, liquid level sensor, etc., and a PID controller. While using such electro-controlled valves is a more complex and expensive solution, it allows to tune very quickly and accurately the performance of each evaporator in the proposed cooling arrangement.

The one or plural valves provided in the proposed cooling arrangement may be electrically insulated such that they electrically isolate a first portion of an inlet channel or an outlet channel directed to an associated evaporator against a second portion of the inlet channel or outlet channel directed to the condenser. Using such electrically isolated valves may be advantageous for high voltage applications as described e.g. in US 5 201 493.

The at least one controllable valve arranged in one of the channels of the thermosyphon may be adapted for controllably adjusting a local fluid pressure loss in the respective channel. In other words, the local fluid pressure loss induced by the controllable valve may be set to various values, i.e. the controllable valve may not only be in one of two positions, i.e. open or closed, but may be set to intermediate positions. Preferably, the controllable valve may be set to a multiplicity of partly opened states resulting in various different local fluid pressure losses. Even more preferably, the controllable valve may be set to each opening state in a continuous range of opening states. An opening state may be referred to as working point of the valve.

In order to control the working point of the at least one valve, the cooling arrangement may further comprise a closed-loop control. Using such closed-loop control, the local pressure fluid loss in a respective channel may be precisely controlled by suitably setting the working point of the associated controllable valve.

Preferably, the control is adapted for adjusting the at least one valve in dependence of a measured cooling load or a predetermined cooling load of at least one of the electric devices to be cooled using the proposed cooling arrangement. In other words, each of the valves comprised in the cooling arrangement may be controlled either in dependence of a measured actual cooling requirement or depending on a predetermined assumption on such cooling requirement.

It shall be noted that possible features and advantages of the invention are described herein with respect to various embodiments of the invention. A person skilled in the art will notice that the features may be suitably combined or replaced in order to create alternative embodiments and possibly achieve synergy effects.

### Brief description of the drawings

Embodiments of the invention will be described with reference to the attached drawings. However, neither the description nor the drawings shall be interpreted as limiting the invention.
Fig. 1 shows a cooling arrangement according to a first embodiment of the present invention.
Fig. 2 shows a cooling arrangement according to a second embodiment of the present invention.
Fig. 3 shows a cooling arrangement according to a third embodiment of the present invention.

The figures are only schematic and not to scale. Same reference signs refer to same or similar features throughout the figures.

### Detailed description of embodiments

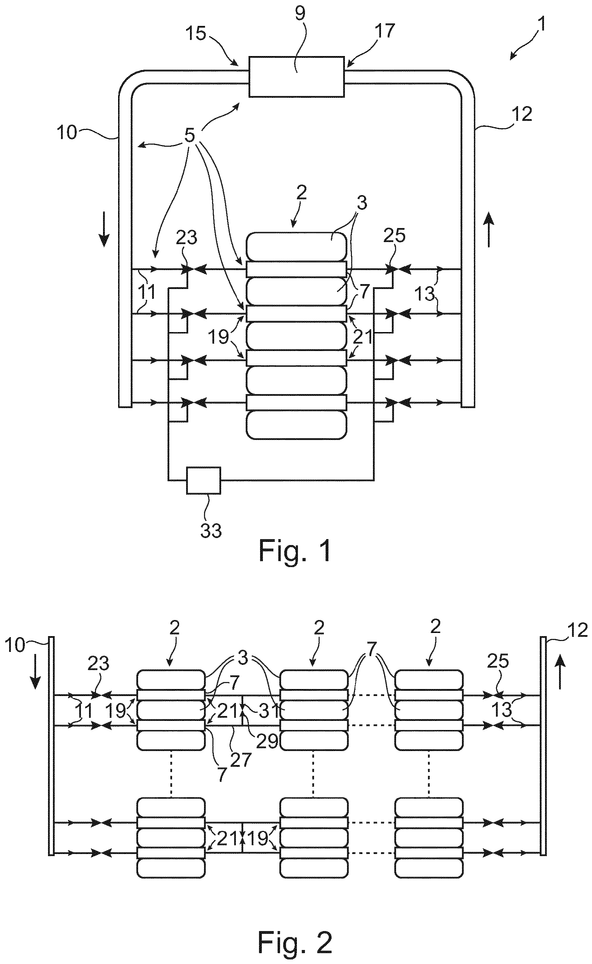

Fig. 1 schematically shows an embodiment of a cooling arrangement 1 for cooling a multiplicity of electric devices 3. While the cooling arrangement 1 may be provided for cooling any type of heat load generating electric devices 3, it is particularly suitable for cooling a plurality of power semiconductor devices.

The cooling arrangement 1 comprises a loop-type two-phase thermosyphon 5. This thermosyphon 5 comprises a plurality of components such as a single condenser 9, a plurality of evaporators 7 and a plurality of inlet channels 11 and outlet channels 13 for connecting the condenser 9 with each of the evaporators 7 such that a flow of coolant medium may circulate in a loop from the condenser 9 to the evaporators 7 and back to the condenser 9 via the inlet and outlet channels 11, 13, respectively.

The electric devices 3 and the evaporators 7 are arranged in an alternating manner in order to provide a stack 2 in which both opposing main surfaces of a device 3 are in thermal and mechanical contact with adjacent evaporators 7 interposed between neighbouring electric devices 3.

The thermosyphon 5 is provided with a piping forming the respective channels in order to enable simultaneous parallel fluid flow from the condenser 9 towards each of the evaporators 7 and back to the condenser 9 for forming a closed loop circuit. In detail, a two-phase fluid serving as a coolant medium may exit the condenser 9 through an outlet 5. The condenser 9 is arranged at an uppermost height level. Accordingly, fluid cooled down in the condenser 9 and therefore having increased density may fall through the common fall channel 10 towards the stack 2 of electrical devices 3 and evaporators 7. In order to distribute the coolant medium comprised in the fall channel 10, a plurality of inlet channels 11 branch off from the common fall channel 10 towards each of the evaporators 7. Accordingly, coolant medium may be supplied through each of the inlet channels 11 and may flow through each of the evaporators 7 via inlets 19 where it may absorb heat generated in each of the adjacent electric devices 3. Upon such heat absorption, the two-phase coolant medium reduces its density and, particularly, increases the content of its vapor phase. After being released from each of the evaporators 7 through outlets 21 and outlet channels 13, the coolant medium is supplied to a common rise channel 12. In this rise channel 12, the coolant medium may return back to the condenser 9 via an inlet 17. Accordingly, the fluid flow of the coolant medium within the thermosyphon is gravity-driven due to the different densities of the coolant medium after releasing thermal energy in the condenser 9, on the one hand, and after absorbing thermal energy in one of the evaporators 7, on the other hand.

However, in a purely gravity-driven thermosyphon, different densities in the coolant medium may result for example in stratification between liquid and vapor phases resulting in non-controllable supply of coolant liquid and vapor bubbles to any of the evaporators 7. Accordingly, cooling characteristics of each of the evaporators 7 may not be controlled.

Therefore, the thermosyphon 5 of the cooling arrangement 1 is provided with a plurality of controllable valves 23, 25. Each of the valves 23, 25 is adapted for adjusting a local fluid pressure loss in one of the inlet channels 11 or outlet channels 13 in which it is installed. For this purpose, the valves are preferably adapted to enable one-way fluid flow only and to establish a specified fluid through flow rate depending on a preset or settable working point of each of the valves.

As shown in Fig. 1, one controllable valve 23 is provided for each of the evaporators 7 in an inlet channel 11 connecting the evaporator 7 to the common fall channel 10.

Accordingly, by suitably adjusting the local fluid pressure loss in each of the controllable valves 23, a supply of coolant medium flowing to each of the evaporators 7 may be precisely controlled. Alternatively or in addition hereto, controllable valves 25 may be arranged in outlet channels 13 connecting each of the evaporators 7 with the common rise channel 12.

Each of the controllable valves 23, 25 is connected to a closed-loop control 33 which is adapted for individually controlling the working point of each of the controllable valves 23, 25. By suitably controlling each of the controllable valves 23, 25, each valve may be adjusted separately such that the flow of coolant medium in each of the evaporators 7 may be adapted to the heat load created by adjacent electric devices 3. Accordingly, using the controllable valves 23, any maldistribution of the fluid flow within the thermosyphon which may occur e.g. due to the arrangement of evaporators 7 at different height levels within the stack 2 may be compensated.

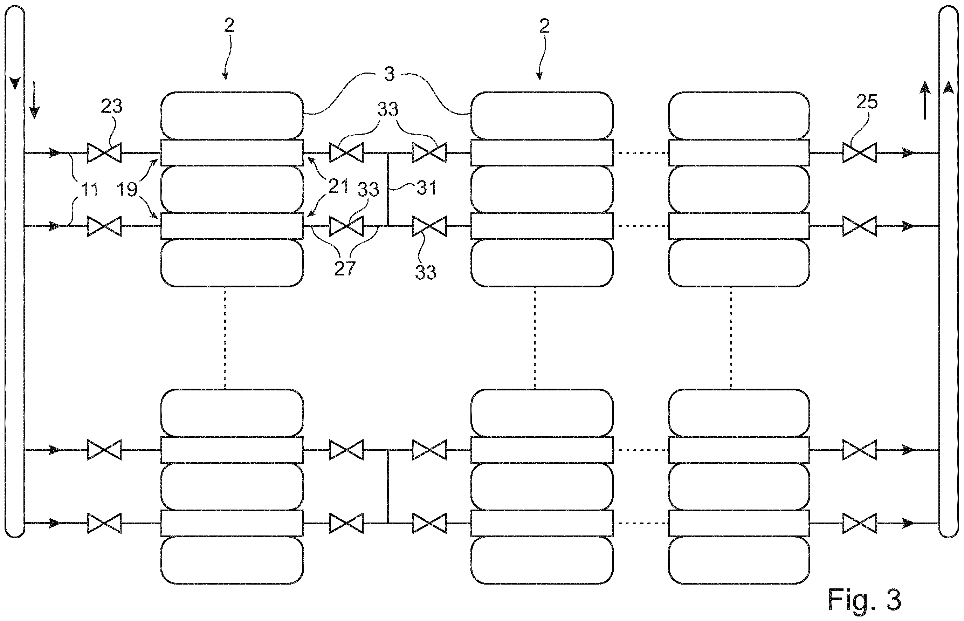

Figs. 2 and 3 show lower portions of alternative cooling arrangements. While in Fig. 1 only one single stack 2 of electric devices 3 and evaporators 7 is shown for the loop-type thermosyphon 5, the embodiments shown in Figs. 2 and 3 comprise a plurality of such stacks 2 arranged in series. Each of the stacks 2 comprises a plurality of electric devices 3 to be cooled and interposed evaporators 7 for heat absorption from these electric devices 3. Inlet channels 11 connected to a common fall channel 10 serve for supplying coolant medium to a left-most stack 2 via inlets 19. After flowing through evaporators 7 of this stack 2 the cooling medium may exit the evaporators 7 via outlets 21 and flow through intermediate channels 27. These intermediate channels 27 serve for interconnecting the evaporators 7 of the left-most stack 2 with evaporators 7 of a neighboring stack 2. As shown in the figures, more than two stacks 2 may be interconnected in series via associated intermediate channels 27.

As shown in Fig. 2, a connection channel 31 is provided for interconnecting neighboring intermediate channels 27. In this connection channel 31 an additional controllable valve 29 is provided in order to enable adjusting a local fluid pressure loss in the respective connection channel 31.

Alternatively, as shown in Fig. 3, additional controllable valves 33 may be arranged within the intermediate channel 27, preferably both upstream and downstream of the connection channel 31. By suitably adjusting the local fluid pressure loss in each of these controllable valves 33, a flow of coolant medium may be precisely controlled to flow from the evaporators 7 of a left stack 2 through one of the intermediate channels 27 and possibly through the connection channel 31 towards one or more of the evaporators 7 of the neighboring right stack 2.

Accordingly, as shown in the embodiments of Figs. 2 and 3, valves 29, 33 may be arranged in a matrix configuration so that the flow of coolant medium may be actively controlled both vertically and horizontally depending on a heat load distribution within the matrix.

Finally, it shall be noted that the embodiments of Figs. 1 to 3 are exemplary only and the number, type and location of valves included in the thermosyphon 5 may differ from the arrangement shown in the figures.

For example, while valves 23, 25, 29, 33 are shown in each of the respective inlet channels 11, outlet channels 13, connection channels 31 and intermediate channels 27, it may be sufficient for specific applications to provide valves only in one or a few of these channels. For example, it may be sufficient to provide controllable valves 23 only in inlet channels 11 while not providing any controllable valves 25 in outlet channels 13, or vice versa.

The controllable valves should preferably be one-way valves enabling a predetermined flow direction of the coolant medium coming from the outlet 15 of the condenser 9 towards the inlet 19 of one of the evaporators 7 and further via the outlets 21 of the evaporators 7 back towards the inlet 17 of the condenser 9.

Furthermore, while a common closed-loop control 13 is shown in the embodiment of Fig. 1 for controlling each of e.g. electro-controlled valves 23, 25, several or each of the controllable valves may be provided as passive valves, i.e. for example manual valves or thermostatic valves, which are not actively controlled during the operation of the cooling arrangement but which have either a fixed predetermined working point to be preset for example during maintenance operation or a working point which is passively set according to a predefined temperature difference, pressure difference, an absolute value or a heat load.

Finally, it shall be noted that the wording such as "comprising", "including" or similar shall not exclude other elements or components to be part of the defined structure and that the term "a" or "an" does not exclude the presence of a plurality of elements. It should also be noted that reference signs in the claims should not be construed as limiting the scope of the claims.

### List of reference signs

- 1: cooling arrangement
- 2: stack
- 3: electric device
- 5: thermo syphon
- 7: evaporators
- 9: condenser
- 10: fall channel
- 11: inlet channels
- 12: rise channel
- 13: outlet channels
- 15: outlet of condenser
- 17: inlet of condenser
- 19: inlets of evaporator
- 21: outlets of evaporator
- 23: controllable valves
- 25: controllable valves
- 27: intermediate channels
- 29: controllable valves
- 31: connection channels
- 33: controllable valves

## Claims

1. A cooling arrangement (1) for a multiplicity of electric devices (3), the cooling arrangement (1) including a two-phase loop thermosyphon (5) comprising:
a multiplicity of evaporators (7), each evaporator (7) being in thermal contact with at least one of the electric devices (3);
at least one condenser (9);
a plurality of inlet channels (11) and outlet channels (13);
wherein each of the evaporators (7) is in fluid communication with the condenser (9) via an inlet channel (11) connecting an outlet (15) of the condenser (9) with an inlet (19) of the respective evaporator (7) and is in fluid communication with the condenser (9) via an outlet channel (13) connecting an outlet (21) of the respective evaporator (7) with an inlet (17) of the condenser (9);
**characterized in that**
at least one controllable valve (23, 25) is arranged in at least one of the inlet channels (11) and outlet channels (13), wherein the controllable valve (23, 25) is adapted for adjusting a local fluid pressure loss in the respective channel (11, 13).

2. The cooling arrangement of claim 1, wherein the multiplicity of evaporators (7) are arranged for establishing parallel fluid flow from and to the condenser (9).

3. The cooling arrangement of claim 1 or 2, wherein the evaporators (7) are arranged at different height levels with respect to the condenser (9).

4. The cooling arrangement of one of claims 1 to 3, wherein the thermosyphon (5) is gravity-driven.

5. The cooling arrangement of one of claims 1 to 4, wherein the valve (23, 25) is a one-way valve for defining a predetermined flow direction of a coolant medium in the cooling arrangement (1).

6. The cooling arrangement of one of claims 1 to 5, wherein a controllable valve (23, 25) is arranged in each of plural ones of the inlet channels (11) and outlet channels (13), wherein each controllable valve (23, 25) is adapted for adjusting a local fluid pressure loss in the respective channel (11, 13).

7. The cooling arrangement of one of claims 1 to 6, wherein a controllable valve (23) is arranged in at least one of each of the inlet channels (11) and each of the outlet channels (13), wherein each controllable valve (23) is adapted for adjusting a local fluid pressure loss of a respective one of an inflow in the respective inlet channel (11) and an outflow in the respective outlet channel (13).

8. The cooling arrangement of one of claims 1 to 7, wherein plural evaporators (7) are arranged serially with an outlet (21) of a first evaporator (7) being in fluid communication with an inlet (19) of a neighboring second evaporator (7) via an intermediate channel (27).

9. The cooling arrangement of claim 8, wherein the cooling arrangement further comprises a connection channel (31) connecting two intermediate channels (27) and the cooling arrangement further comprises at least one controllable valve (29, 33) arranged in one of the intermediate channels (27) and the connection channel (31), wherein each controllable valve (29, 33) is adapted for adjusting a local fluid pressure loss in the respective connection channel (31).

10. The cooling arrangement of one of claims 1 to 9, further comprising a closed-loop control (33) for controlling a working point of the at least one valve (23, 25, 29).

11. The cooling arrangement of claim 10, wherein the control (33) is adapted for adjusting the at least one valve (23, 25, 29) in dependence of one of a measured cooling load and a predetermined cooling load of at least one of the electric devices (3).

12. The cooling arrangement of one of claims 1 to 11, wherein the valve (23, 25, 29, 33) is a manual valve being manually settable to a fixed working point.

13. The cooling arrangement of one of claims 1 to 11, wherein the valve (23, 25, 29, 33) is a thermostatic valve being adapted for automatically passively setting a working point depending on at least one of a measured temperature difference, a measured pressure difference, an absolute value and a measured heat load.

14. The cooling arrangement of one of claims 1 to 11 wherein the valve (23, 25, 29, 33) is an electro-controlled valve being adapted for actively setting a working point in response to a control signal.

15. The cooling arrangement of one of claims 1 to 14, wherein the valve (23, 25, 29, 33) is electrically insulated such that it electrically isolates a first portion of one of the inlet channel (11) and the outlet channel (13) directed to one of the evaporators (7) against a second portion of the respective one of the inlet channel (11) and the outlet channel (13) directed to the condenser (9).

## Patentansprüche

1. Kühlanordnung (1) für eine Mehrzahl elektrischer Vorrichtungen (3), wobei die Kühlanordnung (1) einen als Schleife ausgeführten Zweiphasen-Thermosiphon (5) einschließt, umfassend:
eine Mehrzahl von Verdampfern (7), wobei sich jeder Verdampfer (7) in thermischem Kontakt mit mindestens einer der elektrischen Vorrichtungen (3) befindet;
mindestens einen Kondensator (9);
mehrere Einlasskanäle (11) und Auslasskanäle (13);
wobei jeder Verdampfer (7) fluidkommunizierend mit dem Kondensator (9) über einen Einlasskanal (11) verbunden ist, der einen Auslass (15) des Kondensators (9) mit einem Einlass (19) des betreffenden Verdampfers (7) verbindet, und fluidkommunizierend mit dem Kondensator (9) über einen Auslasskanal (13) verbunden ist, der einen Auslass (21) des betreffenden Verdampfers (7) mit einem Einlass (17) des Kondensators (9) verbindet;
**dadurch gekennzeichnet, dass**
mindestens ein steuerbares Ventil (23, 25) in mindestens einem der Einlasskanäle (11) und Auslasskanäle (13) angeordnet ist, wobei das steuerbare Ventil (23, 25) eingerichtet ist, einen örtlichen Fluiddruckverlust im betreffenden Kanal (11, 13) zu justieren.

2. Kühlanordnung nach Anspruch 1, wobei die Mehrzahl von Verdampfern (7) so angeordnet sind, dass ein paralleler Fluidstrom zum und vom Kondensator (9) hergestellt wird.

3. Kühlanordnung nach Anspruch 1 oder 2, wobei die Verdampfer (7) auf verschiedenen Höhen in Bezug auf den Kondensator (9) angeordnet sind.

4. Kühlanordnung nach einem der Ansprüche 1 bis 3, wobei der Thermosiphon (5) nach dem Prinzip der Schwerkraft arbeitet.

5. Kühlanordnung nach einem der Ansprüche 1 bis 4, wobei das Ventil (23, 25) ein Einwegventil zur Festlegung einer vorbestimmten Strömungsrichtung eines Kühlmediums in der Kühlanordnung (1) ist.

6. Kühlanordnung nach einem der Ansprüche 1 bis 5, wobei in jedem von mehreren Einlasskanälen (11) und Auslasskanälen (13) ein steuerbares Ventil (23, 25) angeordnet ist, wobei jedes steuerbare Ventil (23, 25) eingerichtet ist, einen örtlichen Fluiddruckverlust im betreffenden Kanal (11, 13) zu justieren.

7. Kühlanordnung nach einem der Ansprüche 1 bis 6, wobei in mindestens einem von jedem der Einlasskanäle (11) und jedem der Auslasskanäle (13) ein steuerbares Ventil (23) angeordnet ist, wobei jedes steuerbare Ventil (23) eingerichtet ist, einen örtlichen Fluiddruckverlust eines betreffenden eines Zuflusses im betreffenden Einlasskanal (11) und Abflusses im betreffenden Auslasskanal (13) zu justieren.

8. Kühlanordnung nach einem der Ansprüche 1 bis 7, wobei mehrere Verdampfer (7) in Reihe mit einem Auslass (21) eines ersten Verdampfers (7) angeordnet sind, der fluidkommunizierend über einen Zwischenkanal (27) mit einem Einlass (19) eines benachbarten zweiten Verdampfers (7) verbunden ist.

9. Kühlanordnung nach Anspruch 8, wobei die Kühlanordnung ferner einen Verbindungskanal (31) umfasst, der zwei Zwischenkanäle (27) verbindet, und die Kühlanordnung ferner mindestens ein in einem der Zwischenkanäle (27) und dem Verbindungskanal (31) angeordnetes steuerbares Ventil (29, 33) umfasst, wobei jedes steuerbare Ventil (29, 33) eingerichtet ist, einen örtlichen Fluiddruckverlust im betreffenden Verbindungskanal (31) zu justieren.

10. Kühlanordnung nach einem der Ansprüche 1 bis 9, ferner umfassend eine Regelung (33) zum Regeln eines Arbeitspunktes des mindestens eines Ventils (23, 25, 29).

11. Kühlanordnung nach Anspruch 10, wobei die Regelung (33) eingerichtet ist, das mindestens eine Ventil (23, 25, 29) in Abhängigkeit von einem von einer gemessenen Kühllast und einer vorbestimmten Kühllast mindestens einer der elektrischen Vorrichtungen (3) zu justieren.

12. Kühlanordnung nach einem der Ansprüche 1 bis 11, wobei das Ventil (23, 25, 29, 33) ein manuell betätigtes Ventil ist, das manuell auf einen festen Arbeitspunkt einstellbar ist.

13. Kühlanordnung nach einem der Ansprüche 1 bis 11, wobei das Ventil (23, 25, 29, 33) ein thermostatisches Ventil ist, das eingerichtet ist, einen Arbeitspunkt in Abhängigkeit von mindestens einem von einem gemessenen Temperaturunterschied, einem gemessenen Druckunterschied, einem absoluten Wert und einer gemessenen Wärmelast automatisch passiv einzustellen.

14. Kühlanordnung nach einem der Ansprüche 1 bis 11, wobei das Ventil (23, 25, 29, 33) ein elektrogesteuertes Ventil ist, das eingerichtet ist, einen Arbeitspunkt in Reaktion auf ein Steuersignal aktiv einzustellen.

15. Kühlanordnung nach einem der Ansprüche 1 bis 14, wobei das Ventil (23, 25, 29, 33) elektrisch isoliert ist, so dass es einen zu einem der Verdampfer (7) gerichteten ersten Abschnitt eines des Einlasskanals (11) und des Auslasskanals (13) von einem zweiten Abschnitt des entsprechenden einen des zum Kondensator (9) gerichteten Einlasskanals (11) und Auslasskanals (13) galvanisch trennt.

## Revendications

1. Agencement de refroidissement (1) pour une multiplicité de dispositifs électriques (3), l'agencement de refroidissement (1) comportant un thermosiphon à boucle en deux phases (5) comprenant :
une multiplicité d'évaporateurs (7), chaque évaporateur (7) étant en contact thermique avec au moins l'un des dispositifs électriques (3) ;
au moins un condenseur (9) ;
une pluralité de canaux d'entrée (11) et de canaux de sortie (13) ;
dans lequel chacun des évaporateurs (7) est en communication fluidique avec le condenseur (9) via un canal d'entrée (11) raccordant un orifice de sortie (15) du condenseur (9) à un orifice d'entrée (19) de l'évaporateur (7) respectif et est en communication fluidique avec le condenseur (9) via un canal de sortie (13) raccordant un orifice de sortie (21) de l'évaporateur (7) respectif à un orifice d'entrée (17) du condenseur (9) ;
**caractérisé en ce que**
au moins une soupape commandable (23, 25) est agencée dans au moins l'un des canaux d'entrée (11) et des canaux de sortie (13), dans lequel la soupape commandable (23, 25) est adaptée pour ajuster une perte de pression de fluide locale dans le canal (11, 13) respectif.

2. Agencement de refroidissement selon la revendication 1, dans lequel la multiplicité d'évaporateurs (7) est agencée pour établir un écoulement de fluide parallèle depuis et vers le condenseur (9).

3. Agencement de refroidissement selon la revendication 1 ou 2, dans lequel les évaporateurs (7) sont agencés à des niveaux de hauteur différents par rapport au condenseur (9).

4. Agencement de refroidissement selon l'une des revendications 1 à 3, dans lequel le thermosiphon (5) est entraîné par gravité.

5. Agencement de refroidissement selon l'une des revendications 1 à 4, dans lequel la soupape (23, 25) est une soupape de non-retour pour définir une direction d'écoulement prédéterminée d'un milieu de liquide de refroidissement dans l'agencement de refroidissement (1).

6. Agencement de refroidissement selon l'une des revendications 1 à 5, dans lequel une soupape commandable (23, 25) est agencée dans chacun de la pluralité des canaux d'entrée (11) et des canaux de sortie (13), dans lequel chaque soupape commandable (23, 25) est adaptée pour ajuster une perte de pression de fluide locale dans le canal (11, 13) respectif.

7. Agencement de refroidissement selon l'une des revendications 1 à 6, dans lequel une soupape commandable (23) est agencée dans au moins l'un de chacun des canaux d'entrée (11) et chacun des canaux de sortie (13), dans lequel chaque soupape commandable (23) est adaptée pour ajuster une perte de pression de fluide locale de l'un respectif d'un débit entrant dans le canal d'entrée (11) respectif et d'un débit sortant dans le canal de sortie (13) respectif.

8. Agencement de refroidissement selon l'une des revendications 1 à 7, dans lequel plusieurs évaporateurs (7) sont agencés en série avec un orifice de sortie (21) d'un premier évaporateur (7) en communication fluidique avec un orifice d'entrée (19) d'un second évaporateur voisin (7) via un canal intermédiaire (27).

9. Agencement de refroidissement selon la revendication 8, dans lequel l'agencement de refroidissement comprend en outre un canal de raccordement (31) raccordant deux canaux intermédiaires (27) et l'agencement de refroidissement comprend en outre au moins une soupape commandable (29, 33) agencée dans l'un des canaux intermédiaires (27) et du canal de raccordement (31), dans lequel chaque soupape commandable (29, 33) est adaptée pour ajuster une perte de pression de fluide locale dans le canal de raccordement (31) respectif.

10. Agencement de refroidissement selon l'une des revendications 1 à 9, comprenant en outre une commande à boucle fermée (33) pour commander un point de fonctionnement de l'au moins une soupape (23, 25, 29).

11. Agencement de refroidissement selon la revendication 10, dans lequel la commande (33) est adaptée pour ajuster l'au moins une soupape (23, 25, 29) selon l'une d'une charge de refroidissement mesurée et d'une charge de refroidissement prédéterminée d'au moins l'un des dispositifs électriques (3).

12. Agencement de refroidissement selon l'une des revendications 1 à 11, dans lequel la soupape (23, 25, 29, 33) est une soupape manuelle qui est réglable manuellement à un point de fonctionnement fixe.

13. Agencement de refroidissement selon l'une des revendications 1 à 11, dans lequel la soupape (23, 25, 29, 33) est une soupape thermostatique adaptée pour régler automatiquement passivement un point de fonctionnement selon au moins l'une d'une différence de température mesurée, d'une différence de pression mesurée, d'une valeur absolue et d'une charge calorifique mesurée.

14. Agencement de refroidissement selon l'une des revendications 1 à 11, dans lequel la soupape (23, 25, 29, 33) est une soupape électrocommandée adaptée pour régler activement un point de fonctionnement en réponse à un signal de commande.

15. Agencement de refroidissement selon l'une des revendications 1 à 14, dans lequel la soupape (23, 25, 29, 33) est isolée électriquement de sorte qu'elle isole électriquement une première portion de l'un du canal d'entrée (11) et du canal de sortie (13) dirigée vers l'un des évaporateurs (7) contre une seconde portion de l'un respectif du canal d'entrée (11) et du canal de sortie (13) dirigée vers le condenseur (9).
